Europäisches Patentamt

European Patent Office

Office européen des brevets

(11) Publication number: **0 303 397**
**A1**

# EUROPEAN PATENT APPLICATION

(21) Application number: **88307188.8**

(22) Date of filing: **03.08.88**

(51) Int. Cl.⁴: **G01R 19/175 , H03K 5/153**

(30) Priority: **13.08.87 GB 8719157**

(43) Date of publication of application:
**15.02.89 Bulletin 89/07**

(84) Designated Contracting States:
**BE DE FR GB IT SE**

(71) Applicant: **LUCAS INDUSTRIES public limited company**
**Great King Street**
**Birmingham, B19 2XF West Midlands(GB)**

(72) Inventor: **Edwards, Karl**
**16 Prince William Close**
**Erdington, Birmingham England(GB)**
Inventor: **Halmshaw, Raymond Paul**
**13 Meadowhill Road**
**Redditch B98 8HN England(GB)**

(74) Representative: **Gibson, Stewart Harry et al**
**URQUHART-DYKES & LORD Business**
**Technology Centre Senghennydd Road**
**Cardiff CF2 4AY South Wales(GB)**

(54) **Signal waveform processing circuit.**

(57) A waveform processor for signals delivered by a variable reluctance transducer, used e.g. to sense angular position of a rotor driven by an internal combustion engine in an ignition control system for a vehicle, comprises an integrator having an amplifier (T5, T11) with a feedback integrating capacitor (C2) and a limiting arrangement for limiting the voltage across the integrating capacitor. the limiting arrangement serves to limit the voltage across the integrating capacitor prior to a zero-crossing to be detected in the input signal (VR), by interrupting a component of charging current (normally provided by a source T14) when the voltage at the integrator output (P) reaches a first threshold level in one direction and restoring this component when the voltage at the integrator output (P) returns to a second threshold level.

## SIGNAL WAVEFORM PROCESSING CIRCUIT

This invention relates to a waveform processing circuit or processor, particularly for signals delivered by a variable reluctance transducer.

Variable reluctance transducers (usually with permanent magnet excitation) are used to sense predetermined angular positions of rotary shafts, for example a rotor driven by an internal combustion engine in an ignition control system for a vehicle. The variable reluctance transducer delivers a sharp zero-crossing emf signal from a winding which links with magnetic flux passing between narrow salient teeth on the rotor and stator. These transducers produce spurious noise which is due either to magnetic interference or to small mechanical disturbances of the transducer assembly.

It is known to use integrators to process the output signal from a variable reluctance transducer and thereby discriminate effectively against noise, but integration introduces timing inaccuracies. It is known to minimise this inaccuracy by speeding up the integrator when slewing away from saturation after an over-driving signal from the transducer reverses polarity, but this reduces the discrimination against noise near the zero-crossing instant: in essence this technique relies on the steep slope of the required signal near the zero-crossing to limit mistiming due to noise, but this is not sufficiently effective at low signal amplitudes.

In order for an integrator to discriminate effectively against noise, an adequate integral of the input voltage signal (volt-second integral) is needed to recognise the zero-crossing which is to be sensed, i.e. an indication can be given only after the integrator has registered a volt-second content, following the zero-crossing, greater than that of the worst expected noise. A small delay introduced in this way is acceptable since it corresponds to a consistent small angular interval, providing it is consistently measured. Operational amplifier integrators give rise to measurement uncertainties, owing to imprecise clamping of the feedback capacitor voltage by passive diode limiters (soft clamping). Precise clamping can be achieved by active feedback (hard shunt clamping), but entails operating two operational amplifiers in parallel and this causes difficulties in satisfactorily avoiding parasitic oscillation.

In accordance with this invention, there is provided a waveform processing circuit which comprises an integrator having an amplifier with a feedback integrating capacitor and means for limiting the voltage across the integrating capacitor prior to a zero-crossing to be detected in an input signal, by interrupting a component of capacitor charging current when the integrator output voltage reaches a first threshold level in one direction and restoring said component of charging current when the integrator output voltage returns to a second threshold level.

In a preferred embodiment of waveform processor, a current source makes a constant current of a given sense available to the integrating capacitor. A limiting switch with hysteresis switches this component of charging current away from the capacitor in response to the integrator output voltage reaching its first threshold level in the one direction, and switches the component back to the capacitor in response to the integrator output voltage returning to the second threshold level. A second component of charging current, of opposite sense to the interruptible component, is continuously controlled by the amplifier output in accordance with the input signal received by the processor.

In the preferred embodiment of waveform processor, whilst the first component of charging current is interrupted, a small component of charging current is provided to the capacitor, of the same sense as the interruptible component, so that the voltage across the capacitor continues to rise during the limiter action.

The preferred embodiment of waveform processor comprises a comparator with hysteresis to provide a switched output signal from the circuit. As the integrator output voltage traverses in the one direction towards its first threshold level, the comparator switches from a first state to a second state to provide the output signal. The comparator switches back to its first state when the integrator output voltage returns to another threshold level. Preferably the comparator switches to its second state when the limiting switch interrupts the constant component of charging current to the integrator capacitor, and returns to its first state only after this charging component has been restored. Preferably the switching action of the comparator from its first to its second state is utilised to ensure that interruption of the constant component of charging current occurs abruptly.

In the preferred embodiment of waveform processor, the integrating amplifier comprises an operational amplifier with a virtual earth input node to which the integrator feedback path is connected. When an input signal of a first polarity (corresponding to the one direction of the integrator output) drives the output to its limit, the integrator feedback can no longer control the virtual earth input node, but an accurate feedback limiter is provided to limit the voltage at the input node under these circumstances to a small excursion of the first polarity away from the virtual earth voltage value.

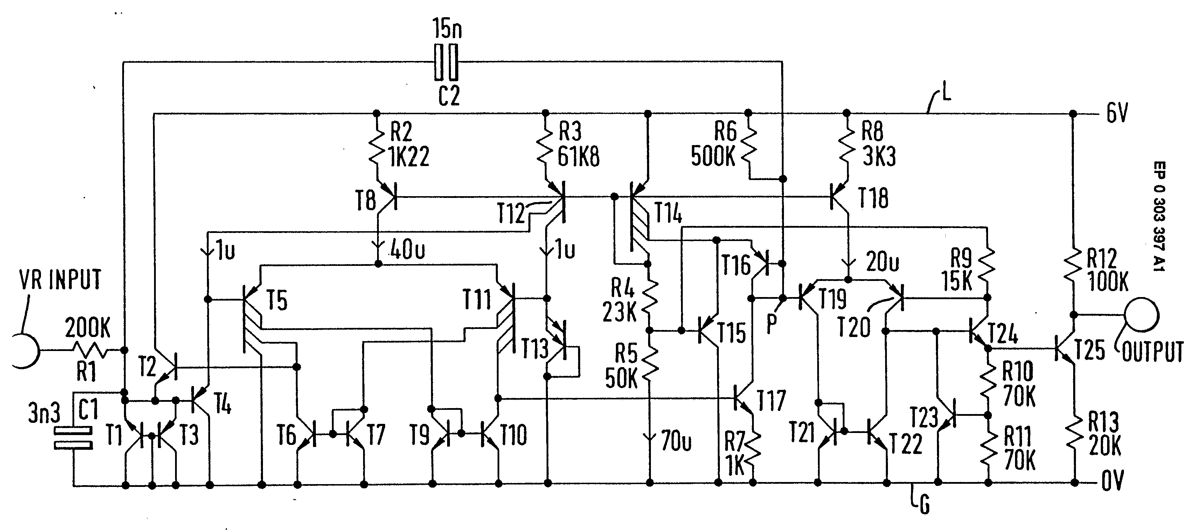

An embodiment of this invention will now be described by way of example only and with reference to the accompanying drawing, the single figure of which is a circuit diagram of a waveform processor for signals delivered by a variable reluctance transducer.

Referring to the drawing, there is shown a waveform processing circuit or processor for signals received at its input VR from a variable reluctance transducer. In the example being described, the transducer is mounted adjacent a circumferentially toothed portion of a rotor driven by an internal combustion engine of a vehicle and it is required to derive an output signal each time a tooth of the rotor portion is aligned with the transducer.

The waveform processor shown in the drawing comprises an integrator having an amplifier with a feedback integrating capacitor C2 and a transistor switch T15 serving as an active output clamp on the integrator and interrupting a charging current normally provided to the integrating capacitor through a constant current source T14, in order to limit the voltage across the capacitor prior to a zero-crossing to be detected in a signal received at an input VR from the transducer.

The integrator comprises an operational amplifier formed by a longtail pair of transistors T5, T11 having their emitter currents supplied through a resistor R2 and transistor T8 from a 6 volt positive supply rail L. Transistors T5 and T11 are of a multi-collector type: transistor T5 has a collector connected through a transistor T6 to ground rail G and another collector connected directly to ground, transistor T11 has two collectors connected through a transistor T10 to ground, whilst transistors T5, T11 each also have two collectors connected to the bases of the transistors T10 and T6 respectively. The bases of transistors T6 and T10 are connected to ground through diodes provided by transistors T7 and T9.

Input buffering and level shifting is provided by input transistors T4 and T13, transistor T13 being of dual-emitter type. Transistors T4 and T13 are supplied with their emitter currents through a resistor R3 and a transistor T12 from the supply rail L, have their collectors connected directly to ground and their emitters connected to the bases of the longtail pair transistors T5, T11 respectively. Transistor T13 has its base and collector interconnected to act as a diode and the input VR is connected to the base of transistor T4 through a series resistor R1. The junction between the collectors of transistors T11 and T10 is connected to the base of a common-emitter transistor stage T17 and the output waveform of the integrator appears at P on the collector of transistor T17.

A constant current load for transistor T17 is provided by transistor T14 of multi-collector type, having its emitter connected directly to the supply rail L and three collectors connected to the integrator output P through a diode provided by a transistor T16. Transistor T14 provides base bias from its other collector for the transistors T8, T12 which have already been described, and also for a further constant current source transistor T18 which will be described below.

The integrating capacitor C2 of the integrator is connected between the output P of the integrator and the base of input transistor T4. The time constant of integration is therefore defined by the feedback capacitor C2 and the series input resistor R1. A capacitor C1 is connected between the base of input transistor T4 and ground and serves to reduce the loop gain of the operational amplifier at high frequency in order to ensure stability. Two oppositely-poled diodes, formed by transistors T1 and T3, are also connected between the base of input transistor T4 and ground and their purposes will be described below.

The transistor switch T15, which serves to switch the current made available to the capacitor feedback loop as will be described, is connected to ground in parallel with transistors T16 and T17 and emitter resistor R7 of transistor T17. The base of transistor switch T15 is connected to the junction between resistors R4 and R5 connected in series between a diode-strapped collector of transistor T14 and ground.

The output P of the integrator forms the input to a comparator which comprises a longtail pair of transistors T19 and T20 receiving their emitter currents from the supply rail L through a resistor R8 and the transistor T18 and having their collectors connected to ground through a transistor T21 (acting as a diode) and a transistor T22, respectively. Transistor T22 has its base fed from the collector of transistor T19. The output P of the integrator is coupled directly to the base of transistor T19 and a reference for the comparator is provided from the junction of resistors R4 and R5 to the base of transistor T20 through a series resistor R9. An emitter follower output transistor T24 of the comparator is connected from the base of transistor T20 and through resistors R10 and R11 to ground. The base of transistor T24 is connected to the collector of transistor T20 and also through a transistor T23 to ground, the base of transistor T23 being connected to the junction between resistors R10 and R11. The processor further comprises an output switching transistor T25 having collector and emitter resistances R12, R13 and its base connected directly to the emitter of transistor T24, the output of the processor being provided at the collector of transistor T25.

With an input signal to the processor of zero volts, the base of transistor T5 would be at a higher voltage (approximately 20 mV higher in the example shown) than the base of transistor T11, owing to the ratio of the emitter areas of the respective input transistors T4 and T13. This offset provides a virtual earth reference voltage of -20 mV for the operational amplifier T5, T11 and ensures that the amplifier output transistor T17 is conducting under quiescent conditions (i.e. input at zero volts).

In conjunction with resistors R4 and R5, transistor T14 forms a current mirror making a constant current available for charging the integrating capacitor C2 through the diode T16 and point P. The base voltage thus provided by transistor T14 also determines the constant currents available from transistors T8, T12 and T18. Integrator output transistor T17 however passes a controlled value of current to ground from point P. As the input signal at VR goes negative, the current flowing into capacitor C2 is controlled by transistor T17 tending to hold the base of input transistor T4 at the virtual earth reference level of -20 mV. This current flowing into the capacitor C2 is the difference between the constant current provided by source transistor T14 and the current sunk to ground by transistor T17. When the input signal at VR goes positive, the capacitor C2 discharges through transistor T17 (now passing more current than is sourced by transistor T14). With either positive or negative input at VR, the output P of the integrator provides a signal which is the integral of the input signal.

The output of the integrator is limited in the negative direction by saturation of transistor T17 and is limited in the positive direction by the clamping action of the transistor switch T15, as will be described below. When output limiting occurs in either direction, the controlling effect of the virtual earth reference is lost and the base of input transistor T4 tends towards the voltage of the input signal VR. This causes the capacitor C2 to acquire an additional charge which must be removed, when the input signal changes polarity, before the integrator returns to its unsaturated active region. In the processor shown, this passive integration is minimised during the negative portions of the input signal VR and limited during its positive portions.

Specifically, the integrator input voltage is limited in the positive direction by the diode transistor T3 connected between the base of input transistor T4 and ground. Further, the input voltage is limited in the negative direction by an active clamp formed by transistors T5, T11, T6, T7 and T2. During normal integration, transistor T6 is saturated due to current in transistors T6 and T7 having a magnitude ratio of approximately 2:1 with balanced conduction in transistors T5 and T11, so that transistor T2 is switched off. However, when the feedback control of the integrator virtual earth input node is lost and its potential has fallen by 20 mV, transistor T5 conducts twice as much current as transistor T11, desaturating transistor T6. Transistor T2 therefore starts to conduct and prevents any further fall in the virtual earth input node voltage of the integrator. As the input voltage subsequently rises, transistor T6 saturates again to switch off transistor T2 and render the input clamp inoperative prior to normal operation of the integrator resuming. Diode transistor T1 protects the operational amplifier in the event of excessive negative input signals which cannot be limited by clamping transistor T2.

As mentioned previously, the output of the integrator is limited in the negative direction (positive input at VR) by saturation of transistor T17 and is limited in the positive direction (negative input at VR) by the clamping action of the transistor switch T15, controlled in part by the comparator T19, T20. The output P of the integrator provides the input to the comparator at the base of transistor T19, the reference for the comparator being provided to the base of transistor T20 through resistor R9 from a clamp reference voltage at the junction of resistors R4 and R5. As the integrator output rises towards the comparator reference, the collector voltage of transistor T22 rises and causes transistor T24 to start conducting when its base reaches 0.6 V (being 1 $V_{be}$). As the current flowing through transistor T24 increases, regenerative feedback occurs because the voltage across its collector resistor R9 increases, lowering the reference voltage of the comparator to the base of its transistor T20 and causing further increase in the voltage at the base of transistor T24. This regenerative action continues until the base of transistor T24 reaches 3 $V_{be}$, when a voltage drop of 1 $V_{be}$ will appear across each of resistors R10 and R11 to switch on transistor T23 and prevent any further rise in the base voltage to transistor T24. The comparator exhibits hysteresis and will not switch off transistor T24 until the integrator output has fallen to a lower threshold voltage. This is because with transistor T24 conducting, the comparator has a lower reference voltage applied to the base of transistor T20. Transistor T24 does not saturate and the $V_{be}$ of transistor T23 defines the current through transistor T24 and hence the hysteresis of the comparator.

The output transistor T25 of the processor starts to conduct when its base voltage reaches 1 $V_{be}$, which occurs when the base of transistor T24 is at 2 $V_{be}$. This condition is reached during the regenerative switching-on of transistor T24 and therefore output transistor T25 switches on rapidly, producing a fast and interference-free output signal from the processor. As the integrator output subsequently falls below the lower threshold of the comparator, regenerative action will occur again to switch off transistor T24 and T25, so that both the positive and negative switching edges of the output signal from the processor are fast.

Switching transistor T15 limits the integrator output in the positive direction as follows. As the integrator output rises towards the comparator reference threshold, the voltages on the bases of transistors T15 and T16 will become equal to cause transistor T15 to conduct and sink the current from transistor T14. The constant current sourced by transistor T14 is no longer available to the integrating capacitor C2. As the comparator also switches at this time, causing transistor T24 to conduct, the voltage at the base of transistor T15 will be reduced thereby ensuring that diode transistor T16 switches off rapidly. Also some hysteresis for switching transistor T15 is provided, because now the voltage on its base is lower than previously and the integrator output will have to fall to a correspondingly lower level before transistor T15 switches off and transistor T16 switches on again. The level at which transistor T15 switches off and transistor T16 switches on again is not as low as the level at which the comparator switches to its prior state. Whilst the switching transistor T15 conducts and interrupts the constant current output of transistor T14 to the integrating capacitor C2, the capacitor voltage continues to rise because of a small current supplied through resistor R6.

It will be appreciated that the hysteresis of the comparator determines the amount of integration of the input waveform which is required after this input changes polarity, before an output signal is produced. This provides the processor with a well-defined noise immunity and signal propagation delay.

When the integrator output traverses in the positive direction and reaches the threshold of the limiting switch transistor T15 and of the comparator T19, T20, output transistor T25 switches on to provide a fast negative edge to the processor output. The input signal at VR from the transducer soon reverses polarity (i.e. the zero-crossing occurs in the input waveform), and when the integrator output falls to the lower threshold of the comparator, output transistor T25 switches off again to provide a fast positive edge to the processor output. This positive edge is used as the indication of the zero-crossing.

At low input frequencies, the output clamp of the integrator is operative for a longer time. The charging effect of the current component through resistor R6 then becomes significant as it increases the amount of integral required to bring the capacitor voltage down to the level at which switching transistor T15 switches off again and the level at which the comparator switches back. This effect retards the switching edge of the processor output at low engine speeds. But because at higher speeds there is a lag in the transducer output (due to eddy currents), then effectively the rising edge of the output signal from the waveform processor occurs at a constant angle, relative to the adjacent position of the transducer saliencies, over the full speed range.

## Claims

1. A waveform processing circuit, comprising an integrator having an amplifier (T5, T11) with a feedback integrating capacitor (C2) and a limiting arrangement for limiting the voltage across the integrating capacitor, **characterised in that** said limiting arrangement (T15, T16) serves to limit the voltage across the integrating capacitor prior to a zero-crossing to be detected in an input signal, by interrupting a component of capacitor charging current when the integrator output voltage (P) reaches a first threshold level in one direction and restoring said component of charging current when the integrator output voltage returns to a second threshold level.

2. A waveform processing circuit as claimed in claim 1, **characterised by** a constant current source (T14) which provides the interruptible component of charging current for said capacitor (C2), said limiting arrangement comprising a switch (T15, T16) with hysteresis which switches said component of current away from the capacitor when the integrator output voltage reaches said first threshold.

3. A waveform processing circuit as claimed in claim 1 or 2, **characterised by** a current source (T17) having a charging current to said capacitor (C2) of opposite sense to the interruptible component and of magnitude controlled by the integrator amplifier (T5, T11).

4. A waveform processor as claimed in any one of claims 1 to 3, **characterised by** a current source (R6) arranged to provide a relatively small component of charging current to said capacitor (C2) whilst said interruptible component is interrupted, so that the voltage across the capacitor continues to rise in said one direction.

5. A waveform processor as claimed in any one of claims 1 to 4, **characterised by** a comparator (T19, T20, T24) with hysteresis serving to provide a switched output signal from the processor as the integrator output voltage traverses towards its said first threshold level.

6. A waveform processor as claimed in claim 5, **characterised in that** the comparator (T19, T20, T24) switches from a first state to a second state when the interruptible component of charging current is interrupted, and returns to its first state after the interruptible component has been restored.

7. A waveform processor as claimed in claim 6, **characterised in that** the comparator (T19, T20, T24) switches abruptly from its first state to its second state and said limiting arrangement (T15, T16) responds to this to ensure abrupt interruption of said interruptible component of charging current.

8. A waveform processor as claimed in any one of the preceding claims, **characterised in that** the integrator amplifier comprises an operational amplifier with a virtual earth input node to which the integrator feedback path is connected, and a feedback limiter (T2) is provided to limit the excursion of the voltage at the input node when the input signal drives the integrator output in said one direction.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | US-A-4 080 574 (ATOMIC ENERGY AUTHORITY) <br> * Abstract; column 3, lines 30-40 * | 1-8 | G 01 R 19/175 <br> H 03 K 5/153 |
| A | EP-A-0 174 518 (FUJI) <br> * Abstract; pages 45-46 * | 1 | |
| A | EP-A-0 117 789 (PEUGEOT) <br> * Abstract * | 1 | |

TECHNICAL FIELDS
SEARCHED (Int. Cl.4)

G 01 R
H 03 K

The present search report has been drawn up for all claims

| Place of search | Date of completion of the search | Examiner |
|---|---|---|
| THE HAGUE | 18-11-1988 | HOORNAERT W. |

EPO FORM 1503 03.82 (P0401)